# EUROPEAN PATENT APPLICATION

(11) **EP 4 510 198 A1**
(43) Date of publication of application: **19.02.2025**
(21) Application number: 24194225.9
(22) Date of filing: 13.08.2024
(51) Int. Cl.: H01L 33/00

(54) **INFRARED LED ELEMENT**

(30) Priority: 17.08.2023 JP 2023132759
(71) Applicant: Ushio Denki Kabushiki Kaisha, Tokyo 100-8150 (JP)
(72) Inventor: SUGIYAMA, Toru, Tokyo, 100-8150 (JP); IIZUKA, Kazuyuki, Tokyo, 100-8150 (JP)
(74) Representative: Maiwald GmbH

(57) **Abstract**

An infrared LED element includes: a conductive support substrate; and a semiconductor laminate and includes a material that can be lattice-matched with InP, in which the semiconductor laminate includes: a first semiconductor layer indicating a first conductivity type; an active layer disposed on an upper layer of the first semiconductor layer; a second semiconductor layer disposed on an upper layer of the active layer and indicating a second conductivity type; and a third semiconductor layer disposed on an upper layer of the second semiconductor layer and contains AlₐGa_{b}In_{c}As indicating the second conductivity type, the third semiconductor layer has an uneven part on a surface opposite to a side on which the second semiconductor layer is positioned, and the third semiconductor layer has band gap energy lower than band gap energy of the second semiconductor layer and higher than band gap energy of the active layer.

## Description

### BACKGROUND OF THE INVENTION

### Field of the Invention

The present invention relates to an infrared light-emitting diode (LED) element, and particularly relates to an infrared LED element having an emission wavelength of 1,000 nm or more.

### Description of the Related Art

In recent years, semiconductor light-emitting elements having an emission wavelength in an infrared region of wavelengths of 1,000 nm or more have been used for a wide variety of applications such as surveillance or monitoring cameras, gas detectors, medical sensors, and industrial equipment.

A semiconductor light-emitting element having an emission wavelength of 1,000 nm or more is generally manufactured through the following procedure. A semiconductor layer of a first conductivity type, an active layer (sometimes referred to as a "light-emitting layer"), and a semiconductor layer of a second conductivity type are epitaxially grown in sequence on an indium phosphide (InP) substrate that acts as a growth substrate, and then an electrode for current injection is formed on the semiconductor wafer. Thereafter, the semiconductor wafer is cut into a chip shape.

Conventionally, in terms of a semiconductor light-emitting element having an emission wavelength of 1,000 nm or more, a semiconductor laser element had been developed ahead of other semiconductor light emitting elements. Meanwhile, the development of LED element has not been advanced as compared to the laser element because of very few applications of the LED element.

However, in recent years, in response to expansion of the range of applications, demand for an infrared LED element with increased efficiency has been growing. As a configuration that meets the requirement, for example, Patent Document 1 discloses an infrared LED element in which electrodes are formed on upper and lower surfaces of a wafer obtained by having an LED structure crystal-grown on an InP substrate, and a current is injected into an active layer by applying a voltage between both electrodes to cause light to be emitted therefrom.

Furthermore, from the spread of applications of the wavelength band, a smaller and shorter LED having higher luminous efficiency is required. As a configuration that meets the requirement,

Patent Document 2 discloses a structure in which a light-emitting diode wafer obtained by crystal-growing an epitaxial semiconductor film having an LED structure on a growth substrate is bonded to a support substrate with a highly reflective film interposed therebetween, and then the growth substrate is thinned or completely removed.

### Prior Art Documents

### Patent Documents

Patent Document 1: JP-A-4-282875
Patent Document 2: JP-A-2012-129357
Patent Document 3: JP-A-2023-018332
Patent Document 4: JP-A-2012-074489

### SUMMARY OF THE INVENTION

The growth substrate and the semiconductor layer of the infrared LED element having an emission wavelength of 1,000 nm or more is constituted of a material including a combination of a plurality of elements among aluminum (Al), gallium (Ga), indium (In), arsenic (As), and phosphorus (P). Many of these materials are known to have high refractive indices. For example, InP has a refractive index of about 3.1 to 3.3 for light having a wavelength of 1,000 nm or more and 2,000 nm or less. Therefore, in a case of extracting the light from the InP substrate side, most of the light generated in the semiconductor layer is totally reflected at a boundary between the InP substrate and air unless any processing is performed on the InP substrate. It is assumed that the light reflected at the interface with the InP substrate and returned to the active layer side is further repeatedly reflected and then extracted to the outside, but a part of the light is absorbed in the process of traveling in the InP substrate or in the semiconductor layer, and as a result, the extraction efficiency is reduced.

Further, in the infrared LED element, in order to extract more light, etching with a chemical solution is performed to form an uneven shape on the light extraction surface. However, as mentioned in Patent Document 3, a method of providing an uneven shape on the surface of the InP substrate by a simple chemical etching treatment has not been established, the uneven shape appearing with the same degree of randomness as that of gallium nitride (GaN)-based or gallium arsenide (GaAs)-based LED elements. Forthis reason, in the infrared LED element using the main surface of the InP substrate as the light extraction surface, when an uneven shape is formed on the light extraction surface by etching with a chemical solution, randomness becomes insufficient, and there is a problem that a plurality of peaks (multiple peaks) appear in a spectrum of emitted light.

Note that, in the infrared LED element using InP as a growth substrate, InP is generally used as a semiconductor layer that is lattice-matched with the substrate, and InP is also used for a light extraction surface forming a rough surface. Therefore, as a method of forming an uneven shape, a method of performing a dip treatment (wet etching) with an acid-based etching solution without using a patterning mask on the light extraction surface as disclosed in Patent Document 4 is known, but the problem of multiple peaks cannot be solved as described above.

Here, a phenomenon in which multiple peaks appears in the emission spectrum occurs when light propagates in a thin region sandwiched between a pair of interfaces exhibiting reflectivity. In view of this point, it is considered that appearance of multiple peaks can be suppressed by decreasing the reflectance of the light extraction surface. In the GaN-based or GaAs-based LED element described above, the main surface of the semiconductor layer constituting the light extraction surface is etched to randomly roughen the surface. As a result, the appearance of multiple peaks in the emission spectrum of the GaN-based or GaAs-based LED element is suppressed.

In the GaN-based or GaAs-based LED element, the above method can be adopted because the method that enables highly reproducible etching to be performed on the main surface of the semiconductor layer has been established. In the case of the GaN-based element, because the nitrogen polar surface ([000-1] plane) has relatively low chemical stability and high defect density, a rough surface can be relatively easily formed by etching with a chemical solution such as KOH. In addition, in the case of the GaAs-based element, because As is an element that is relatively easily oxidized, by performing etching while forming a micromask on the surface by using an etchant added with an oxidizing agent, a rough surface can be easily formed.

However, at the time of the present invention, a method for randomly roughening the surface with good reproducibility has not been established in the InP-based LED element. The reason for this is that InP has higher stability and lower defect density than the nitrogen polar surface of GaN, and an oxide micromask is difficult to be suitably formed. Furthermore, as described above, the demand for the InP-based LED element has been low so far as compared with the GaN-based or GaAs-based LED element, and there is also a circumstance that development of an etchant that can randomly roughen the surface has not progressed. In addition, even if such an etchant is developed, in view of the above circumstances, the cost thereof is assumed to be extremely expensive.

Furthermore, in the infrared LED element having a vertical structure, an electrode is disposed on the upper surface of the light extraction surface. In a case where the light extraction surface is roughened, the roughening needs to be performed while intentionally avoiding the region where the electrode is formed. Due to such circumstances, high reproducibility is required in roughening the surface.

Due to the above circumstances, in the InP-based infrared LED element, a method that can randomly roughen the surface with good reproducibility has not been practically used at the present time.

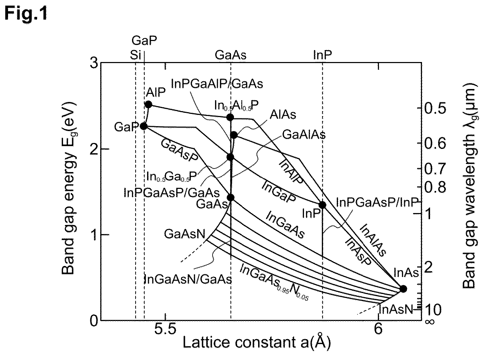

Therefore, attention has been paid to an As-containing material in which the dip treatment method is generally performed as a method for forming an uneven shape. In GaAs and AlGaAs generally used in the red LED elements, it is known that a relatively random uneven shape is formed without having a patterning mask formed, by being dipped in an etching solution containing nitric acid. However, when GaAs or AlGaAs is used in an infrared LED element using an InP substrate as a growth substrate, crystal defects are introduced due to lattice mismatch. In particular, in a structure in which a growth substrate is peeled off and bonded to a support substrate as disclosed in Patent Document 2, a layer forming an uneven shape is grown at the initial stage of crystal growth, and therefore, crystal defects introduced by the lattice mismatch pass through an active layer, which causes a decrease in luminous efficiency and reliability. Therefore, on the basis of a correlation diagram regarding the band gap energy of semiconductor materials illustrated in Fig. 1, the present inventors have focused on AIGalnAs which is an As-containing material considered to be easy to have an uneven shape formed and is lattice-matched with InP.

By changing an n-InP layer used as the light extraction surface to a layer of n-AIGalnAs, it has been confirmed that an uneven shape can be easily formed. Then, it has been confirmed that there is an effect of suppressing multiple peaks, which is one of the purposes of forming an uneven shape on the light extraction surface.

However, the present inventors have noticed that by changing the entire n-type layer from InP to AIGalnAs, the infrared LED element is reduced in luminous efficiency particularly when driven by a large current as compared with the element having the structure before the change.

In view of the above problems, an object of the present invention is to provide an infrared LED element in which an uneven shape can be efficiently formed on a light exit surface and luminous efficiency does not easily decrease even in a case of being driven with a large current.

A semiconductor light-emitting element according to the present invention is an infrared LED element that can emit infrared light having a peak wavelength of 1,000 nm to 2,000 nm, the infrared LED element including:
a support substrate having conductivity; and
a semiconductor laminate disposed on an upper layer of the support substrate and includes a material that can be lattice-matched with InP, in which
the semiconductor laminate includes:
   a first semiconductor layer disposed on a side closest to the support substrate and indicating a first conductivity type;
   an active layer disposed on an upper layer of the first semiconductor layer;
   a second semiconductor layer disposed on an upper layer of the active layer and indicating a second conductivity type different from the first conductivity type; and
   a third semiconductor layer disposed on an upper layer of the second semiconductor layer and including AlₐGa_{b}In_{c}As (0 ≤ a < 1,0 < b < 1, 0 < c < 1, a + b + c = 1) indicating the second conductivity type,
the third semiconductor layer has an uneven part on a surface opposite to a side on which the second semiconductor layer is positioned, and
the third semiconductor layer has band gap energy lower than band gap energy of the second semiconductor layer and higher than band gap energy of the active layer.

As a result of intensive studies, the present inventors have inferred that when the entire n-type layer is changed from InP to AIGalnAs in the conventional infrared LED element, a decrease in the luminous efficiency occurs due to a decrease in the band gap energy difference between the active layer and the n-type layer. In general, a structure in which the active layer is sandwiched between p-type and n-type semiconductors having large bandgap energy is adopted. This is because electrons and holes contributing to light emission are confined in the active layer and efficiently recombined. However, when the bandgap energy difference between the active layer and the n-type layer or between the active layer and the p-type layer is small, electrons and holes tend to leak easily from the active layer before recombination. That is, it is considered that the decrease in the luminous efficiency as described above is caused by the reduction in the difference in the bandgap energy between the active layer and the n-type layer.

On the basis of the above inference, the present inventors have considered forming, in a semiconductor laminate, a roughening layer that is an As-containing material considered to be easy to have an uneven shape formed and that lattice-matches with InP, and a cladding layer (second semiconductor layer) that has large band gap energy and is less likely to cause a decrease in luminous efficiency.

In the infrared LED element having the above configuration, similarly to the conventional configuration, because the second semiconductor layer is formed on the upper layer of the active layer, the bandgap energy difference between the active layer and the second semiconductor layer is maintained to the same extent as in the conventional configuration. Furthermore, in the third semiconductor layer constituting the light exit surface, an uneven part for improving light extraction efficiency is formed easier than with InP.

Therefore, in the infrared LED element having the above configuration, an uneven shape can be efficiently formed on the light exit surface and luminous efficiency does not easily decrease even in a case of being driven with a large current.

In the infrared LED element, the second semiconductor layer may include InP.

InP has the largest bandgap energy among material systems lattice-matched with the InP substrate. Therefore, InP is suitable as a material of the second semiconductor layer (cladding layer).

In the LED element, the third semiconductor layer may have a thickness of 1 µm to 5 µm.

When the third semiconductor layer is too thin, it is extremely difficult to form a rough surface, and when the third semiconductor layer is too thick, an electric resistance value increases. Therefore, it is preferable that the third semiconductor layer has a thickness that allows formation of the rough surface and does not cause a problem in the electric resistance value, and specifically, the thickness is preferably in a range of 1 µm to 5 µm.

The infrared LED element includes a first electrode disposed in contact with a part of an upper surface of the third semiconductor layer, in which the third semiconductor layer may have a dopant concentration higher than a dopant concentration of the second semiconductor layer and may be 5 × 10¹⁷/cm³ or more.

Further, in the infrared LED element, the second semiconductor layer may have a dopant concentration of 5 × 10¹⁷/cm³ or more, and the third semiconductor layer may have a dopant concentration of 1 × 10¹⁸/cm³ or more.

In the configuration in which the first electrode is formed on a part of the upper surface of the third semiconductor layer, the third semiconductor layer functions as a contact layer that electrically connects the first electrode and the second semiconductor layer. Therefore, it is more important that the third semiconductor layer has a lower electric resistance value than the second semiconductor layer. In addition, in a case where the dopant concentration of the third semiconductor layer is less than 5 × 10¹⁷/cm³, the electric resistance value increases, which may lead to a problem of temperature rise during operation.

In the above configuration, by adjusting the dopant concentration of the second semiconductor layer and the third semiconductor layer as described above, the third semiconductor layer functions as a contact layer having a sufficiently small electric resistance value between the first electrode and the second semiconductor layer. Furthermore, considering that the second semiconductor layer functions as a cladding layer, it is more preferable that a dopant concentration of the second semiconductor layer is 5 × 10¹⁷/cm³ or more, and a dopant concentration of the third semiconductor layer is 1 × 10¹⁸/cm³ or more.

Further, the infrared LED element may include: a second electrode disposed on a surface of the support substrate, the surface being opposite to a surface on which the semiconductor laminate is disposed; and a reflection layer including a conductive material and disposed between the support substrate and the semiconductor laminate.

According to the above configuration, the reflection layer reflects the light generated in the active layer and traveling toward the first conductor layer side, that is, the side opposite to the light exit surface formed on the main surface of the third semiconductor layer, toward the light exit surface side. Therefore, the infrared LED element having the above configuration can extract more light generated in the active layer from the light exit surface.

In the infrared LED element, the second semiconductor layer may have band gap energy of 1.1 times or more band gap energy of the active layer.

By establishing the above relationship between the band gap energy of the second semiconductor layer and the band gap energy of the active layer, a decrease in efficiency is further suppressed.

In the infrared LED element, the uneven part formed on the surface of the third semiconductor layer may have a surface roughness (Ra) of 0.25 to 1.00.

According to the present invention, an infrared LED element in which an uneven shape can be efficiently formed on a light exit surface and luminous efficiency does not easily decrease even in a case of being driven with a large current can be realized.

### BRIEF DESCRIPTION OF THE DRAWINGS

Fig. 1 is a correlation diagram regarding band gap energy of a semiconductor material;
Fig. 2 is a cross-sectional view schematically illustrating a structure of an infrared LED element according to a first embodiment;
Fig. 3A is a cross-sectional view for describing one step in a manufacturing method of the infrared LED element illustrated in Fig. 2;
Fig. 3B is a cross-sectional view for describing one step in the manufacturing method of the infrared LED element illustrated in Fig. 2;
Fig. 3C is a cross-sectional view for describing one step in the manufacturing method of the infrared LED element illustrated in Fig. 2;
Fig. 3D is a cross-sectional view for describing one step in the manufacturing method of the infrared LED element illustrated in Fig. 2;
Fig. 3E is a cross-sectional view for describing one step in the manufacturing method of the infrared LED element illustrated in Fig. 2;
Fig. 3F is a cross-sectional view for describing one step in the manufacturing method of the infrared LED element illustrated in Fig. 2;
Fig. 3G is a cross-sectional view for describing one step in the manufacturing method of the infrared LED element illustrated in Fig. 2;
Fig. 3H is a cross-sectional view for describing one step in the manufacturing method of the infrared LED element illustrated in Fig. 2;
Fig. 3I is a cross-sectional view for describing one step in the manufacturing method of the infrared LED element illustrated in Fig. 2;
Fig. 3J is a cross-sectional view for describing one step in the manufacturing method of the infrared LED element illustrated in Fig. 2;
Fig. 3K is a cross-sectional view for describing one step in the manufacturing method of the infrared LED element illustrated in Fig. 2; and
Fig. 3L is a cross-sectional view for describing one step in the manufacturing method of the infrared LED element illustrated in Fig. 2.

### DETAILED DESCRIPTION OF THE PREFERRED EMBODIMENTS

Hereinafter, an infrared LED element according to the present invention will be described with reference to the drawings. Note that each of the following drawings concerning the infrared LED element is schematically illustrated, and the dimensional ratio and the number in the drawings do not necessarily coincide with the actual dimensional ratio and the actual number.

In the present specification, the expression "a layer B is formed on an upper layer of a layer A" is intended to include a case in which the layer B is formed on a surface of the layer A with a thin film interposed therebetween, as well as a case in which the layer B is formed directly on the surface of the layer A. Note that the "thin film" referred to herein may indicate a layer having a film thickness of 50 nm or less and preferably a layer having a film thickness of 10 nm or less.

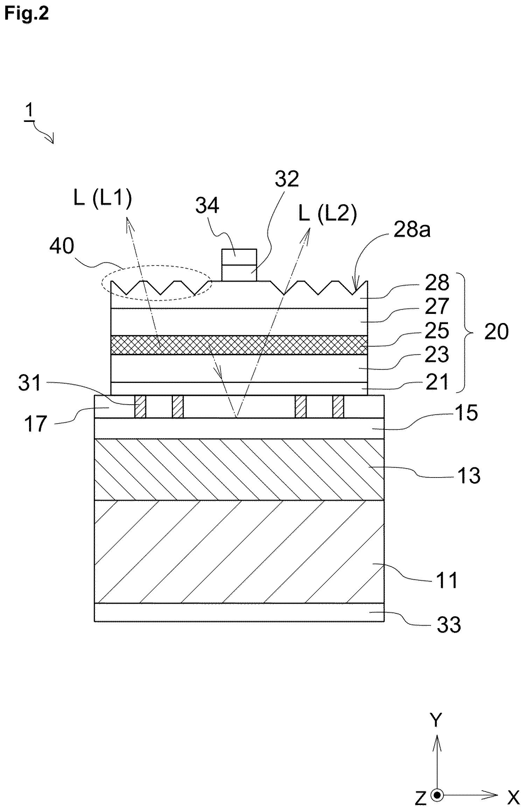

Fig. 2 is a cross-sectional view schematically illustrating a structure of the infrared LED element according to the present embodiment. An infrared LED element 1 illustrated in Fig. 2 includes a semiconductor laminate 20 disposed on the upper layer (+Y side) of a support substrate 11. The infrared LED element 1 illustrated in Fig. 2 corresponds to a schematic cross-sectional view taken along the XY plane at a predetermined position. In the description given hereinafter, reference is made as appropriate to an XYZ coordinate system added to Fig. 2.

In the following description, positive and negative orientations distinguished from each other for directional expression will be described as a "+X direction" and a "-X direction" by adding positive and negative signs. In addition, a direction expressed without distinction between positive and negative orientations will be described simply as the "X direction". Namely, in the present specification, in a case where the direction is simply described as the "X direction", both the "+X direction" and the "-X direction" are included. The same applies to the Y direction and the Z direction.

In the infrared LED element 1, infrared light L is generated in the semiconductor laminate 20 (more specifically, in an active layer 25 described later). More specifically, as illustrated in Fig. 2, the infrared light L (L1, L2) is extracted in the +Y direction with respect to the active layer 25. The infrared light L has a peak wavelength of 1,000 nm to 2,000 nm.

### [Element structure]

Hereinafter, the structure of the infrared LED element 1 will be described in detail.

### (Support substrate 11)

The support substrate 11 includes, for example, a semiconductor such as silicon (Si) or germanium (Ge), or a metal material such as copper (Cu) or copper-tungsten (CuW). In a case where the support substrate 11 is constituted of a semiconductor, the support substrate may be doped with a dopant at high concentration so as to have electrical conductivity. As an example, the support substrate 11 is a Si substrate doped with boron (B) at a dopant concentration of 1 × 10¹⁹/cm³ or more and having a resistivity of 10 mΩ·cm or less. As the dopant, for example, phosphorus (P), arsenic (As), antimony (Sb), or the like can be used in addition to B. From the viewpoint of achieving both high heat dissipation and low manufacturing cost, the support substrate 11 is preferably an Si substrate.

The thickness (length in the Y direction) of the support substrate 11 is not particularly limited, but is, for example, 50 µm to 500 µm, and preferably 100 µm to 300 µm.

### (Metal bonding layer 13)

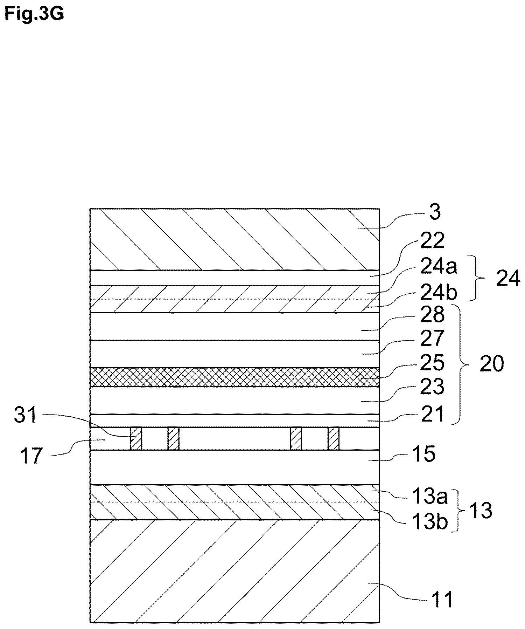

The infrared LED element 1 includes a metal bonding layer 13 disposed on the upper layer of the support substrate 11. The metal bonding layer 13 includes a low-melting solder material such as gold (Au), gold-zinc (Au-Zn), gold-tin (Au-Sn), gold-indium (Au-In), Au-Cu-Sn, Cu-Sn, palladium-tin (Pd-Sn), or Sn. As will be described later with reference to Fig. 3G, the metal bonding layer 13 is used for bonding a growth substrate 3 on the upper surface of which the semiconductor laminate 20 is formed and the support substrate 11. The thickness of the metal bonding layer 13 is not particularly limited, but is, for example, 0.5 µm to 5.0 µm, and preferably 1.0 µm to 3.0 µm.

Note that barrier layers may be formed on the upper and lower layers of the metal bonding layer 13. The barrier layer is provided in some cases for the purpose of suppressing diffusion of a solder material constituting the metal bonding layer 13. The material is not limited as long as such a function is realized, but the barrier layer can be realized by, for example, a material containing titanium (Ti), platinum (Pt), tungsten (W), molybdenum (Mo), nickel (Ni), or the like. A more specific example is a Ti/Pt/Au laminate.

### (Reflection layer 15)

The infrared LED element 1 according to the present embodiment includes a reflection layer 15 disposed on the upper layer of the metal bonding layer 13.

The reflection layer 15 has a function of reflecting infrared light L2 traveling toward the support substrate 11 side (-Y direction) among the infrared light L generated in the active layer 25 and guiding the infrared light L2 in the +Y direction. The reflection layer 15 includes a conductive material and a material exhibiting high reflectance to the infrared light L. The reflectance of the reflection layer 15 with respect to the infrared light L is 50% or more, preferably 70% or more, more preferably 80% or more, and particularly preferably 90% or more.

In a case where the peak wavelength of the infrared light L is 1,000 nm to 2,000 nm, silver (Ag), an Ag alloy, Au, Al, Cu, or the like can be used as the material of the reflection layer 15. This material can be appropriately selected according to the wavelength of the infrared light L.

The thickness of the reflection layer 15 is not particularly limited, but is, for example, 0.1 µm to 2.0 µm inclusive, and preferably 0.3 µm to 1.0 µm inclusive.

Note that, in a case where the barrier layer as described above is formed between the reflection layer 15 and the metal bonding layer 13, a decrease in reflectance of the reflection layer 15 due to diffusion of the material constituting the metal bonding layer 13 toward the reflection layer 15 can be suppressed.

From the viewpoint of improving the light extraction efficiency, it is preferable that the infrared LED element 1 includes the reflection layer 15 as illustrated in Fig. 2, but in the present invention, whether or not the infrared LED element 1 includes the reflection layer 15 is optional.

Furthermore, although not illustrated, from the viewpoint of improving the light extraction efficiency, the infrared LED element 1 preferably includes an antireflection film that covers the upper surface, the side surface, or both of the upper and side surfaces of the semiconductor laminate 20. However, whether or not the infrared LED element 1 includes the antireflection film is optional. Note that, for example, using silicon dioxide (SiOz), silicon nitride (SiN), or the like as a material, the film thickness of the antireflection film is appropriately determined so as to have an optical film thickness such that the reflectance decreases from the refractive index and the emission wavelength, and the antireflection film is formed on the upper surface, the side surface, or both of the upper and side surfaces of the semiconductor laminate 20 by a plasma chemical vapor deposition (CVD) method.

### (Insulating layer 17)

The infrared LED element 1 illustrated in Fig. 2 includes an insulating layer 17 disposed on the upper layer of the reflection layer 15. The insulating layer 17 includes a material that exhibits electrical insulation and has high transparency to the infrared light L. Transmittance of the insulating layer 17 to the infrared light L is preferably 70% or more, more preferably 80% or more, and particularly preferably 90% or more.

In a case where the peak wavelength of the infrared light L is 1,000 nm to 2,000 nm, SiO₂, SiN, aluminum oxide (Al₂O₃), zirconia oxide (ZrO), hafnium oxide (HfOz), magnesium oxide (MgO), or the like can be used as the material of the insulating layer 17. This material can be appropriately selected according to the wavelength of light generated in the active layer 25.

### (Semiconductor laminate 20)

The infrared LED element 1 illustrated in Fig. 2 includes a semiconductor laminate 20 disposed on the upper layer of the insulating layer 17. The semiconductor laminate 20 is a laminate of a plurality of semiconductor layers, and includes, for example, a first contact layer 21, a first cladding layer 23, an active layer 25, and a second cladding layer 27. Each of the semiconductor layers (21,23,25, and 27) constituting the semiconductor laminate 20 includes a material that can be epitaxially grown while being lattice-matched with the growth substrate 3 to be described later.

The entire thickness of the semiconductor laminate 20 is 30 µm (30,000 nm) or less, and preferably 5 µm to 20 µm.

### <<First contact layer 21 and first cladding layer 23>>

In the present embodiment, the first contact layer 21 includes, for example, p-type GalnAsP. The thickness of the first contact layer 21 is not limited, and is, for example, 10 nm to 1,000 nm, and preferably 50 nm to 500 nm. Further, the concentration of a p-type dopant in the first contact layer 21 is preferably 5 × 10¹⁷/cm³ to 3 × 10¹⁹/cm³, more preferably 1 × 10¹⁸/cm³ to 2 × 10¹⁹/cm³.

In the present embodiment, the first cladding layer 23 is disposed on the upper layer of the first contact layer 21 and includes p-type InP. The thickness of the first cladding layer 23 is not limited, but is, for example, 1,000 nm to 10,000 nm, and preferably 2,000 nm to 5,000 nm. The concentration of a p-type dopant in the first cladding layer 23, at a position apart from the active layer 25, preferably ranges from 1 × 10¹⁷/cm³ to 3 × 10¹⁸/cm³ inclusive, and more preferably ranges from 5 × 10¹⁷/cm³ to 3 × 10¹⁸/cm³ inclusive.

As the p-type dopant contained in the first contact layer 21 and the first cladding layer 23, a material such as Zn, Mg, or beryllium (Be), preferably Zn or Mg, and particularly preferably Zn can be used. In the present embodiment, the first contact layer 21 and the first cladding layer 23 correspond to a "first semiconductor layer".

### <<Active layer 25>>

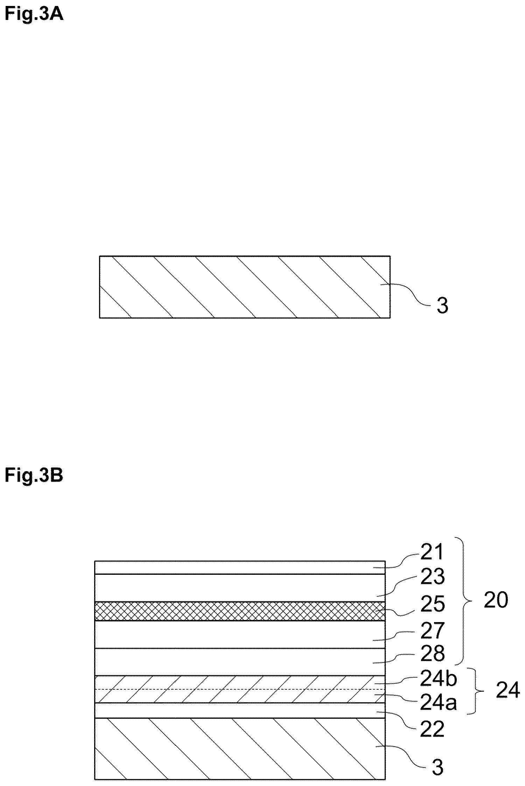

In the present embodiment, the active layer 25 is a semiconductor layer formed on the upper layer of the first cladding layer 23. A material of the active layer 25 is appropriately selected from material that can generate light of a target wavelength and can be epitaxially grown while being lattice-matched with the growth substrate 3 as described later with reference to Fig. 3B and the like.

In manufacturing the infrared LED element 1 that emits the infrared light L having a peak wavelength of 1,000 nm to 2,000 nm, the active layer 25 may have a single-layer structure including GalnAsP, AIGalnAs, or InGaAs, or may have a multiple quantum well (MQW) structure that includes a well layer including GalnAsP, AIGalnAs, or InGaAs and a barrier layer including GalnAsP, AIGalnAs, InGaAs, or InP that is greater in band gap energy than the well layer.

In a case where the active layer 25 has the single-layer structure, the active layer 25 has a film thickness of 50 nm to 2,000 nm, and preferably 100 nm to 300 nm. Furthermore, in a case of the MQW structure, the active layer 25 is formed by laminating the well layer and the barrier layer, each having a film thickness of 5 nm to 20 nm, in a range of 2 cycles to 50 cycles.

The active layer 25 may be doped with an n-type or p-type dopant or may be undoped. In a case where the active layer 25 is doped with the n-type dopant, the dopant may be, for example, Si.

### <<Second cladding layer 27>>

In the present embodiment, the second cladding layer 27 is disposed on the upper layer of the active layer 25 and is constituted of n-type InP. The second cladding layer 27 needs to have a certain film thickness and impurity concentration for the purpose of current dispersion. The thickness of the second cladding layer 27 is not limited, and is, for example, 2,000 nm to 15,000 nm, and preferably 5,000 nm to 10,000 nm. The concentration of the n-type dopant in the second cladding layer 27 is preferably 5 × 10¹⁷/cm³ or more, more preferably 1 × 10¹⁸/cm³. Note that, in a case where the current dispersion and the like is also taken into consideration, a range of the concentration of the n-type dopant in the second cladding layer 27 is preferably 5 × 10¹⁷/cm³ to 1 × 10¹⁹/cm³, more preferably 1 × 10¹⁸/cm³ to 5 × 10¹⁸/cm³.

Materials for the first and the second cladding layers 23 and 27 are selected appropriately from ones that do not absorb the infrared light L generated in the active layer 25 and that can be epitaxially grown by being lattice-matched to the growth substrate 3 (see Fig. 3B). In a case where an InP substrate is adopted as the growth substrate 3, InP, GalnAsP, AIGalnAs, or the like can be used as a material of the first cladding layer 23 and the second cladding layer 27, but InP is preferable.

In addition, although optional, from the viewpoint of suppressing a decrease in efficiency, the band gap energy of the second cladding layer 27 is preferably 1.1 times or more the band gap energy of the active layer 25.

### <<Second contact layer 28>>

In the present embodiment, the material of the second contact layer 28 is disposed on the upper layer of the second cladding layer 27 and is appropriately selected from materials satisfying AlₐGa_{b}In_{c}As (0 ≤ a < 1, 0 < b < 1, 0 < c < 1, a + b + c = 1). More specifically, for example, AIGalnAs, InGaAs, or the like can be used.

For the second contact layer 28, a material having band gap energy lower than that of the second cladding layer 27 and higher than that of the active layer 25 is selected.

In the present embodiment, the second contact layer 28 includes, for example, n-type Al-GaInAs. The thickness of the second contact layer 28 is not limited, but is preferably 1 µm to 5 µm, and more preferably 2 µm to 4 µm. The concentration of the n-type dopant in the second contact layer 28 is preferably 5 × 10¹⁷/cm³ or more, and more preferably 1 × 10¹⁸/cm³ or more.

Note that, in a case where the current dispersion and the like is also taken into consideration, a range of the concentration of the n-type dopant in the second contact layer 28 is preferably 5 × 10¹⁷/cm³ to 3 × 10¹⁹/cm³, and more preferably 1 × 10¹⁸/cm³ to 2 × 10¹⁹/cm³. In addition, although optional, from the viewpoint of relatively reducing the electric resistance value, the dopant concentration of the second contact layer 28 is preferably configured to be higher than the dopant concentration of the second cladding layer.

As the n-type impurity material doped in the second cladding layer 27 and the second contact layer 28, Sn, Si, sulfur (S), Ge, selenium (Se), or the like can be used, and Si is particularly preferable. The second cladding layer 27 corresponds to a "second semiconductor layer", and the second contact layer 28 corresponds to a "third semiconductor layer".

As illustrated in Fig. 2, in the infrared LED element 1 according to the present embodiment, an uneven part 40 is formed on the +Y side surface (hereinafter, referred to as a "first surface 28a") of the second contact layer 28. The uneven part 40 is schematically illustrated in a periodic shape in Fig. 2, but actually has a random uneven shape formed by dip treatment using an etching solution. Here, although optional, from the viewpoint of enhancing the light extraction efficiency, the viewpoint of ease of formation, and the like, a surface roughness (Ra) of the uneven part 40 is preferably 0.25 to 1.00.

### (Internal electrode 31)

The infrared LED element 1 illustrated in Fig. 2 has an internal electrode 31 formed penetrating in the Y direction at a plurality of locations in the insulating layer 17. The internal electrode 31 electrically connects the first semiconductor layer (21, 23) and the support substrate 11. The internal electrodes 31 are preferably provided at a plurality of positions dispersed in a direction parallel to the XZ plane (that is, a direction parallel to the main surface of the support substrate 11).

The internal electrode 31 includes a material that can form an ohmic connection with the first contact layer 21. As an example, the internal electrode 31 includes AuZn, AuBe, or a laminated structure (for example, Au/Zn/Au or the like) containing at least Au and Zn. Note that these materials have lower reflectance for the infrared light L than the materials constituting the reflection layer 15.

A shape of the pattern of the internal electrodes 31 when viewed in the Y direction is optional. However, from the viewpoint of allowing a flow of the electric current across a wide range in the active layer 25 in a direction parallel to the main surface (XZ plane) of the support substrate 11 (hereinafter, referred to as a "plane direction"), the internal electrodes 31 are preferably disposed at a plurality of places that are dispersed in the plane direction.

The total area of all the internal electrodes 31 when viewed in the Y direction is preferably 30% or less, more preferably 20% or less, and particularly preferably 15% or less with respect to the area in the plane direction of the semiconductor laminate 20 (for example, the active layer 25). If the total area of the internal electrodes 31 becomes relatively large, the amount of infrared light L2 traveling from the active layer 25 to the support substrate 11 side (-Y direction) and absorbed by the internal electrodes 31 increases, leading to deterioration of the light extraction efficiency. On the other hand, if the total area of the internal electrodes 31 becomes too small, the resistance value increases, leading to an increase in the forward voltage.

### (Upper-surface electrode 32)

The infrared LED element 1 illustrated in Fig. 2 includes an upper-surface electrode 32 disposed on the upper surface of the semiconductor laminate 20. Typically, the plural pieces of the upper-surface electrodes 32 are formed to extend in a predetermined direction. As an example, the plurality of upper-surface electrodes 32 extends in the X direction and the Z direction along the side of the semiconductor laminate 20 and has a comb shape. However, the shape of the arrangement pattern of the upper-surface electrode 32 is optional, and may be, for example, a lattice shape or a spiral shape.

The upper-surface electrodes 32 are formed over a wide range on the XZ plane while exposing the surface of the second contact layer 28 located in the lower layer (-Y side) (directly or except for a part of the dielectric layer formed on the same surface). This enables the electric current flowing in the active layer 25 to expand in a direction parallel to the XZ plane direction and thus enables light emission in a wide range in the active layer 25.

The upper-surface electrode 32 includes, for example, a material such as AuGe/Ni/Au or AuGe, and may include a plurality of these materials. Note that the upper-surface electrode 32 corresponds to a "first electrode".

### (Pad electrode 34)

As illustrated in Fig. 2, the infrared LED element 1 includes a pad electrode 34 disposed on the upper surface of a part of the upper-surface electrode 32. Note that, in Fig. 2, the pad electrode 34 is illustrated as being formed on the entire surface of the upper-surface electrode 32, but this is for convenience of illustration. In practice, the pad electrode 34 may be formed on a part of the surface of the upper-surface electrode 32 extending in the plane direction.

The pad electrode 34 includes, for example, Ti/Au, Ti/Pt/Au, or the like. This pad electrode 34 is provided for the purpose of securing a region to be brought into contact with a bonding wire for power supply, but it is optional whether or not the pad electrode 34 is provided in the present invention.

### (Back-surface electrode 33)

The infrared LED element 1 illustrated in Fig. 2 includes a back-surface electrode 33 formed on a surface (the -Y side) of the support substrate 11 opposite the semiconductor laminate 20. The back-surface electrode 33 is brought into ohmic contact with the support substrate 11. The back-surface electrode 33 includes, for example, a material such as Ti/Au or Ti/Pt/Au, and may contain two or more of these materials. Note that the back-surface electrode 33 corresponds to a "second electrode".

### [Manufacturing method]

An example of a manufacturing method of the above-described infrared LED element 1 will be described with reference to each of Figs. 3A to 3L. Figs. 3A to 3L are each a cross-sectional view illustrating a step in a manufacturing process. Note that the order of the following procedures may be appropriately changed as long as the procedures do not affect the manufacture of the infrared LED element 1.

### (Step S1)

As illustrated in Fig. 3A, the growth substrate 3 is prepared. In the present embodiment, an InP substrate having a (001) plane as one main surface is suitably used as the growth substrate 3. An example of the thickness of the substrate is 370 µm, and the diameter of the main surface thereof is 2 inches. However, the thickness and size of the growth substrate 3 are appropriately set.

### (Step S2)

The growth substrate 3 is conveyed into, for example, a metal organic chemical vapor deposition (MOCVD) apparatus, and a buffer layer 22, an etching stop layer (ES layer) 24, the second contact layer 28, the second cladding layer 27, the active layer 25, the first cladding layer 23, and the first contact layer 21 are sequentially epitaxially grown on the growth substrate 3 to form the semiconductor laminate 20 (see Fig. 3B). In this step S2, the type and the flow rate of the raw material gas, the treatment time, the environmental temperature, and the like are appropriately adjusted according to the material of the layer to be grown or the film thickness.

A formation example of the semiconductor laminate 20 is as follows. First, n-type InP doped with Si is laminated on the growth substrate 3 with a predetermined film thickness (for example, about 500 nm) to obtain the buffer layer 22. Next, a layer (here, an InGaAs layer) of a material different from that of the buffer layer 22 is laminated with a predetermined film thickness (for example, about 200 nm) to obtain an ES layer 24a. Next, a layer (here, an InP layer) of a material different from that of the ES layer 24a is laminated with a predetermined film thickness (for example, about 300 nm) to obtain an ES layer 24b. Thereafter, the second contact layer 28, the second cladding layer 27, the active layer 25, the first cladding layer 23, and the first contact layer 21 are sequentially formed in a state where growth conditions are set so as to have the film thickness and the composition described above. Note that, in a case where the second semiconductor layer has a function of the ES layer, the ES layer 24 may not be formed.

As a detailed example, AIGalnAs is laminated with a film thickness of 5,000 nm to obtain the second contact layer 28. Next, n-type InP using Si as a dopant is laminated with a film thickness of 3,000 nm to obtain the second cladding layer 27. Next, InGaAsP is laminated with a film thickness of 900 nm to obtain the active layer 25. Here, the condition is such that the peak wavelength of the infrared light L emitted from the infrared LED element 1 is 1,300 nm. However, as described above, the peak wavelength of the infrared light L can be adjusted within a range of 1,000 nm to 2,000 nm by adjusting the composition ratio of the materials constituting the active layer 25 or adopting the MQW structure.

Thereafter, p-type InP using Zn as a dopant is laminated with a film thickness of 3,000 nm to form the first cladding layer 23, and successively, p-type InGaAsP using Zn as a dopant is laminated with a film thickness of 200 nm to form the first contact layer 21.

### (Step S3)

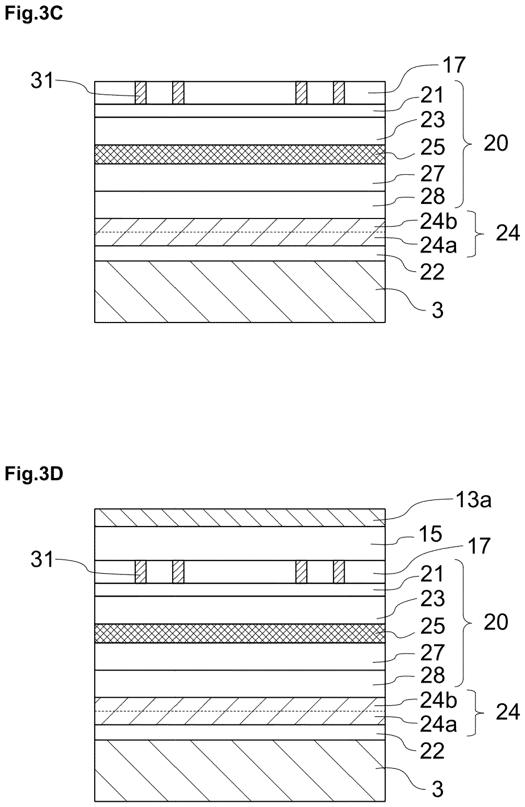

After a wafer on which the semiconductor laminate 20 is formed on the growth substrate 3 is taken out from the MOCVD apparatus, the insulating layer 17 including, for example, SiO₂ is formed by the plasma CVD method (see Fig. 3C). An example of the film thickness of the insulating layer is 200 nm. Next, a resist mask patterned by a photolithography method is formed on the surface of the insulating layer 17. After the insulating layer 17 formed in the resist opening is removed by an etching method using a predetermined chemical such as buffered hydrofluoric acid, a material film of the internal electrode 31 including, for example, Au/Zn/Au is formed by using an electron beam (EB) vapor deposition apparatus. An example of the film thickness of the material film of the internal electrode 31 is Au/Zn/Au = 25 nm/25 nm/150 nm.

Next, after the resist mask is removed, the material film formed in the unnecessary region is lifted off to form the internal electrode 31 (see Fig. 3C). Thereafter, an annealing treatment is performed through heat treatment, for example, at 450°C for 10 minutes to form an ohmic contact between the first contact layer 21 and the internal electrode 31.

### (Step S4)

As shown in Fig. 3D, the reflection layer 15 and a metal bonding layer 13a are sequentially formed on the upper surface of the insulating layer 17. For example, Al/Au is deposited with a predetermined film thickness by the EB vapor deposition apparatus to form the reflection layer 15, and successively, Ti/Au is deposited with a predetermined film thickness to form the metal bonding layer 13a. The metal bonding layer 13a may be the same material as the metal bonding layer 13 described above.

An example of the film thickness of the reflection layer 15 is Al/Au = 5 nm/200 nm. An example of the film thickness of the metal bonding layer 13a is Ti/Au = 150 nm/1,500 nm. Note that, as described above, a barrier layer may be formed between the reflection layer 15 and the metal bonding layer 13a. An example of the film thickness of the barrier layer is Ti/Pt/Au = 150 nm/300 nm/200 nm.

### (Step S5)

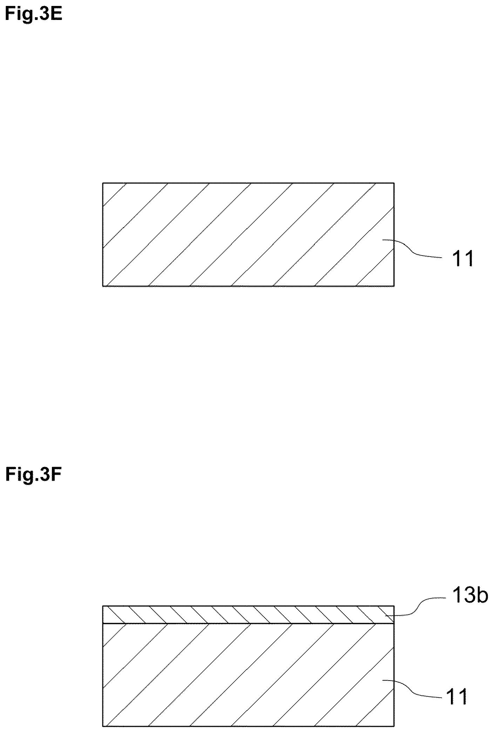

As illustrated in Fig. 3E, the support substrate 11 different from the growth substrate 3 is prepared. In the present embodiment, a conductive Si substrate having a (001) plane as one main surface and highly doped with B is used. The electric resistivity of the support substrate 11 is preferably less than 10 mΩ·cm (= 0.1 mΩ·m). Note that, as described above, a barrier layer may be formed between the support substrate 11 and a metal bonding layer 13b.

### (Step S6)

As illustrated in Fig. 3F, the metal bonding layer 13b is formed on the main surface of the support substrate 11. The metal bonding layer 13b can be formed by the same method as the metal bonding layer 13a described above in step S4.

### (Step S7)

As illustrated in Fig. 3G, the growth substrate 3 and the support substrate 11 are bonded to each other with the metal bonding layer 13 (13a, 13b) interposed therebetween while being pressurized by using, for example, a wafer bonding device. Preferably, the surfaces of the respective metal bonding layers 13 (13a, 13b) are stacked together in a cleaned state. This bonding treatment is performed, for example, at 300°C and 1 MPa. By this treatment, the metal bonding layer 13a on the growth substrate 3 and the metal bonding layer 13b on the support substrate 11 are melted and integrated (metal bonding layer 13).

### (Step S8)

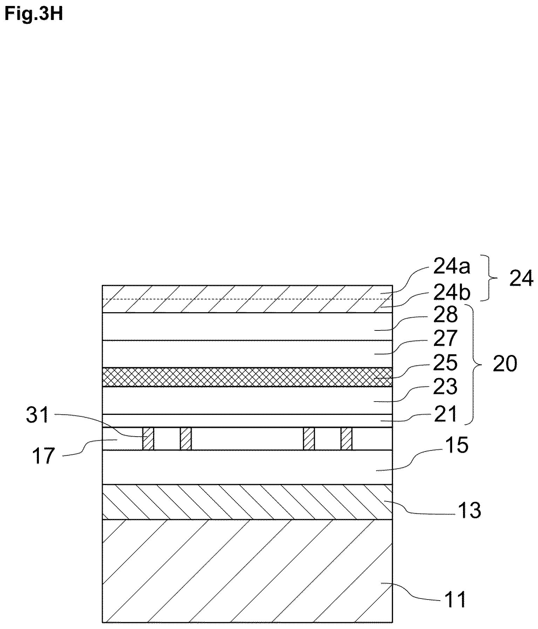

As illustrated in Fig. 3H, the growth substrate 3 is removed. As an example, the growth substrate 3 is removed by immersing the bonded wafer in a hydrochloric acid-based etchant. At this time, because the ES layer 24 formed of a material different from the growth substrate 3 and the buffer layer 22 is insoluble in a hydrochloric acid-based etchant, the etching treatment is stopped when the ES layer 24a is exposed.

### (Step S9)

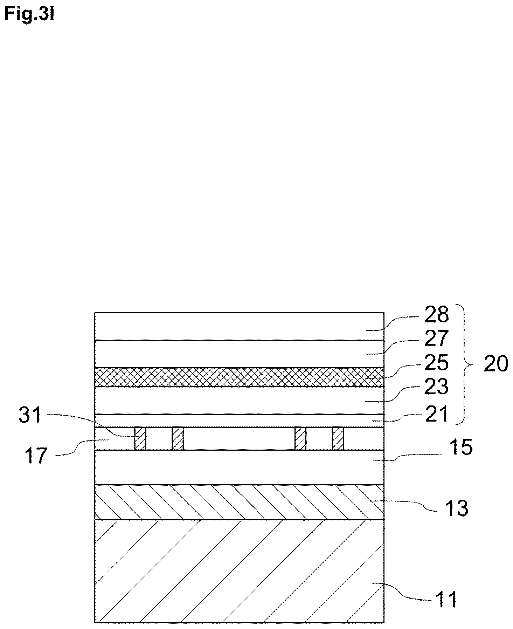

As illustrated in Fig. 3I, the ES layer 24a and the ES layer 24b are removed to expose the second contact layer 28. For example, after cleaning with pure water as necessary, the ES layer 24a is removed by being immersed in a predetermined chemical solution that melts the ES layer 24a but does not melt the ES layer 24b. As a chemical solution for removing the ES layer 24a, for example, a mixed solution of sulfuric acid and hydrogen peroxide water (SPM) can be used. Thereafter, the ES layer 24b is removed by being immersed in a predetermined chemical solution that melts in the ES layer 24b but does not melt the second contact layer 28. As a chemical solution for removing the ES layer 24b, for example, a hydrochloric acid-based etchant can be used.

### (StepS10)

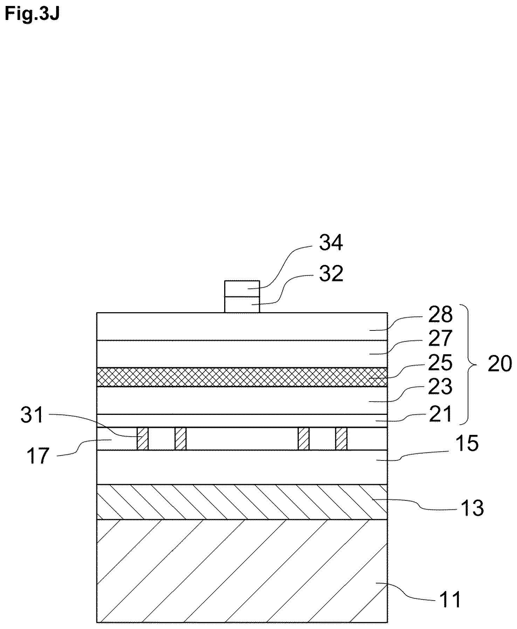

As shown in Fig. 3J, the upper-surface electrode 32 is formed on the exposed surface of the second contact layer 28. Specifically, the following procedure is performed.

A resist mask patterned by the photolithography method is formed on the surface of the second contact layer 28. Next, after a material for forming the upper-surface electrode 32 (for example, Au/Ge/Au) is deposited by the EB vapor deposition apparatus, the lift-off is performed to form the upper-surface electrode 32. An example of the film thickness of the upper-surface electrode 32 is Au/Ge/Au = 10 nm/30 nm/150 nm.

Thereafter, in order to realize the ohmic properties of the upper-surface electrode 32, annealing treatment is performed by heat treatment at, for example, 450°C for 10 minutes.

Next, the pad electrode 34 is formed on the upper surface of the upper-surface electrode 32 at a predetermined position. Similarly to the case of the upper-surface electrode 32, the formation in this case can also be realized by the film forming step and the lift-off step by the EB vapor deposition apparatus. As the pad electrode 34, for example, Ti/Pt/Au is deposited, and an example of the thickness thereof is Ti/Pt/Au = 150 nm/300 nm/1,500 nm.

### (StepS11)

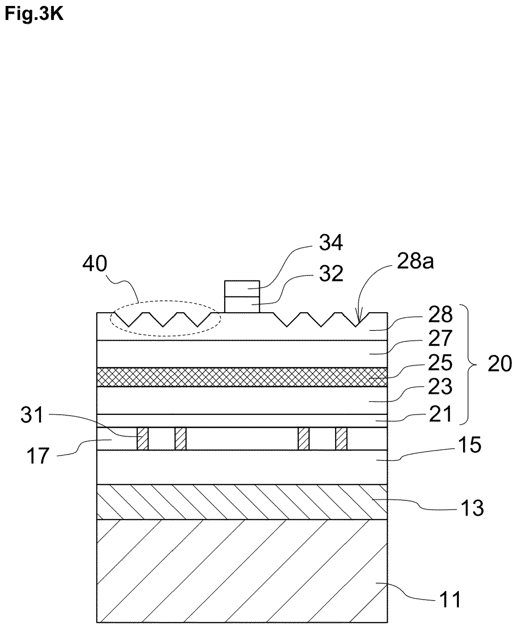

As shown in Fig. 3K, the uneven part 40 is formed on the first surface 28a of the second contact layer 28.

As an example of a specific method, first, a resist patterned on the first surface 28a of the second contact layer 28 on the basis of the photolithography method is formed. This resist is formed so as to cover the upper portion of the region where the upper-surface electrode 32 is formed.

Through this patterned resist, etching is performed on the first surface 28a of the second contact layer 28 by using an etchant such as a sulfuric acid-nitric acid mixed solution. In this manner, the uneven part 40 having a random uneven shape is formed on the first surface 28a of the second contact layer 28. As the etchant, for example, a nitric acid-water mixed solution is used.

Thereafter, the resist is removed with a cleaning liquid such as acetone. As an example of the etchant, for example, resist stripping solutions sold by various resist manufacturers are used.

### (StepS12)

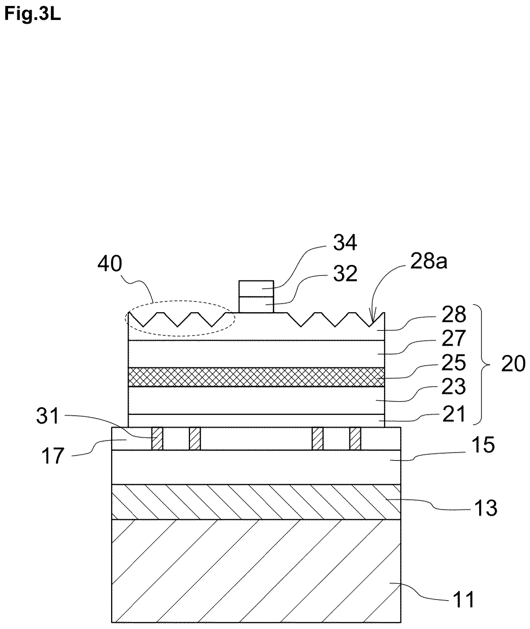

As illustrated in Fig. 3L, mesa etching for separating into each element is performed. Specifically, wet etching is performed by using a predetermined etchant while a non-etched region of the surface of the second contact layer 28 is masked by a resist patterned by the photolithography method. As a result, a part of the semiconductor laminate 20 located in the unmasked region is removed.

As an example of a specific method, first, the second contact layer 28 and the second cladding layer 27 are removed by etching using a hydrochloric acid-phosphoric acid mixed solution. This reaction is stopped when the active layer 25 is exposed. Next, the active layer 25 is removed by etching using a mixed solution of sulfuric acid and hydrogen peroxide water (SPM). This reaction is stopped in the first cladding layer 23. Next, the first cladding layer 23 is partially removed by etching using the hydrochloric acid-phosphoric acid mixed solution. Thereafter, the resist is removed by a cleaning liquid such as acetone. The first cladding layer 23 and the first contact layer 21 may be removed to expose the insulating layer 17.

### (StepS13)

After the thickness on the back surface side of the support substrate 11 is adjusted, the back-surface electrode 33 is formed on the back surface side of the support substrate 11 (see Fig. 2). As a specific method of forming the back-surface electrode 33, similarly to the upper-surface electrode 32, the back-surface electrode 33 can be formed by depositing a material for forming (for example, Ti/Pt/Au) the back-surface electrode 33 by a vacuum vapor deposition apparatus. An example of the film thickness of the back-surface electrode 33 is Ti/Pt/Au = 150 nm/300 nm/1,500 nm.

A method of adjusting the thickness of the support substrate 11 is optional, but as an example, a method of grinding with a back grinder in a state where the semiconductor laminate 20 side is attached to a back grind tape can be adopted. The thickness after the grinding is adjusted, for example, within a range within 50 µm to 250 µm, and is appropriately selected according to the application of the infrared LED element 1 and the subsequent process. As a specific example, the thickness of the support substrate 11 after the grinding is 150 µm. After the grinding processing is completed, the tape is peeled off and the substrate is cleaned.

Note that the adjustment of the thickness on the back surface side of the support substrate 11 may be performed as necessary, and is not necessarily an essential step.

### (StepS14)

Next, the support substrate 11 is diced together to form chips. For example, in a state where the back-surface electrode 33 side is attached with a dicing tape, dicing is performed together with the support substrate 11 from the upper-surface electrode 32 side along a dicing line formed by the mesa etching in step S13, by using a diamond blade or the like.

Thereafter, the chipped infrared LED element 1 is mounted on a stem or the like by using a conductive adhesive such as an Ag paste. The pad electrode 34 is connected to a post portion of the stem by wire bonding.

In the infrared LED element 1 having the above configuration, similarly to the conventional configuration, because the second cladding layer 27 corresponding to the second semiconductor layer is formed on the upper layer of the active layer 25, the bandgap energy difference between the active layer and the second semiconductor layer is maintained to the same extent as in the conventional configuration. Furthermore, in the second contact layer 28 constituting the light exit surface (first surface 28a), the uneven part 40 for improving the light extraction efficiency is easily formed as compared with InP. Therefore, in the infrared LED element 1, an uneven shape can be efficiently formed on the light exit surface (first surface 28a) and the luminous efficiency does not easily decrease even in a case of being driven with a large current.

In the above embodiment, the first semiconductor layer (first contact layer 21 and first cladding layer 23) is a p-type semiconductor, and the second semiconductor layer (second contact layer 28 and second cladding layer 27) is an n-type semiconductor. However, the conductivity types of the first semiconductor layer and the second semiconductor layer may be reversed.

## Claims

1. An infrared light-emitting diode (LED) element (1) that can emit infrared light (L) having a peak wavelength of 1,000 nm to 2,000 nm, the infrared LED element (1) comprising:
a support substrate (11) having conductivity; and
a semiconductor laminate (20) disposed on an upper layer of the support substrate (11) and includes a material that can be lattice-matched with indium phosphide (InP), wherein
the semiconductor laminate (20) includes:
a first semiconductor layer (21, 23) disposed on a side closest to the support substrate (11) and indicating a first conductivity type;
an active layer (25) disposed on an upper layer of the first semiconductor layer (21, 23);
a second semiconductor layer (27) disposed on an upper layer of the active layer (25) and indicating a second conductivity type different from the first conductivity type; and
a third semiconductor layer (28) disposed on an upper layer of the second semiconductor layer (27) and including AlₐGa_{b}In_{c}As (0 ≤ a < 1, 0 < b < 1, 0 < c < 1, a + b + c = 1) indicating the second conductivity type,
the third semiconductor layer (28) has an uneven part (40) on a surface opposite to a side on which the second semiconductor layer (27) is positioned, and
the third semiconductor layer (28) has band gap energy lower than band gap energy of the second semiconductor layer (27) and higher than band gap energy of the active layer (25).

2. The infrared LED element (1) according to claim 1, wherein the second semiconductor layer (27) includes indium phosphide (InP).

3. The infrared LED element (1) according to claim 1 or 2, wherein the third semiconductor layer (28) has a thickness of 1 µm to 5 µm.

4. The infrared LED element (1) according to claim 1 or 2, further comprising
a first electrode (32) disposed in contact with a part of an upper surface of the third semiconductor layer (28), wherein
the third semiconductor layer (28) has a dopant concentration higher than a dopant concentration of the second semiconductor layer (27) and is 5 × 10¹⁷/cm³ or more.

5. The infrared LED element (1) according to claim 4, wherein
the second semiconductor layer (27) has a dopant concentration of 5 × 10¹⁷/cm³ or more, and
the third semiconductor layer (28) has a dopant concentration of 1 × 10¹⁸/cm³ or more.

6. The infrared LED element (1) according to claim 4, further comprising:
a second electrode (33) disposed on a surface of the support substrate (11), the surface being opposite to a surface on which the semiconductor laminate (20) is disposed; and
a reflection layer (15) including a conductive material and disposed between the support substrate (11) and the semiconductor laminate (20).

7. The infrared LED element (1) according to claim 1 or 2, wherein the second semiconductor layer (27) has band gap energy of 1.1 times or more band gap energy of the active layer (25).

8. The infrared LED element (1) according to claim 1 or 2, wherein the uneven part (40) formed on a surface of the third semiconductor layer (28) has a surface roughness (Ra) of 0.25 to 1.00.
